# FASCICULE DE BREVET EUROPEEN

(11) **EP 0 664 073 B1**
(45) Date de publication et mention de la délivrance du brevet: **20.01.1999**
(21) Numéro de dépôt: 94922930.6
(22) Date de dépôt: 18.07.1994
(51) Int. Cl.: H05K 3/40, H01R 9/22, B60R 16/02

(54) **PROCEDE DE REALISATION D'UN CIRCUIT CONDUCTEUR**
VERFAHREN ZUR HERSTELLUNG EINER LEITENDEN SCHALTUNG
METHOD FOR PRODUCING A CONDUCTIVE CIRCUIT

(30) Priorité: 09.08.1993 FR 9309785
(43) Date de publication de la demande: 26.07.1995
(73) Titulaire: DAV, F-74106 Annemasse Cédex (FR)
(72) Inventeur: EDMOND, Jean-Pierre, F-74100 Etrembières (FR)
(74) Mandataire: Levy, David
(86) Numéro de dépôt international: FR9400892
(87) Numéro de publication internationale: WO9505061

(56) Documents cités:
- FR-A- 2 356 247
- US-A- 5 229 922

## Description

La présente invention concerne un procédé de réalisation d'un circuit électrique et un circuit électrique découpé muni de languettes de connexion et un commutateur qui comprend ce circuit.

Dans la conception et la fabrication de commutateurs à touche de commande, du type push-push notamment, on utilise des circuits électriques qui sont obtenus par découpe d'une plaque conductrice, de manière à ménager des pistes conductrices qui peuvent être indépendantes ou reliées entre elle par des pontets. Des organes de liaison électrique, tels que des "haltères", appelés ainsi en raison de leur forme analogue à une haltère, des contacts à au moins deux points, assurent la conduction électrique entre différentes pistes, lorsqu'ils sont commandés. Ces commutateurs sont dotés de languettes de connexion qui sont insérés dans des réceptacles d'un boîtier d'interconnexion, par exemple. Les pistes conductrices qui peuvent être surmoulées sur une face ou sur les deux faces, comportent généralement des orifices pour la réception et le maintien des extrémités des languettes de connexion. Une telle technique est décrite et représentée dans les brevets FR-82 13846 et FR-87 14039.

Une autre technique est décrite et représentée dans les brevets US-A-4 085 502 et FR-A-2 356 247.

Dans la demande FR-92 011992, non encore publiée et déposée au nom de la demanderesse, il est décrit un circuit conducteur découpé dont certaines parties formant support d'organe sont repliées pour constituer des languettes de connexion. Toutefois, de telles languettes de connexion sont prévues en divers endroits de la périphérie du circuit découpé, ce qui implique une correspondance entre les languettes de connexion et leurs réceptacles montés sur les boîtiers d'interconnexion. De plus, il existe une possibilité d'erreur lors de la connexion entre le commutateur avec ses languettes de connexion et le boîtier d'interconnexion, du fait que lesdites languettes de connexion ne sont et ne peuvent être orientées en raison de la structure du circuit découpé et de leur emplacement sur ledit circuit découpé.

La présente invention a pour but de proposer un procédé de réalisation d'un circuit électrique muni de languettes de connexion qui soit simple à réaliser et qui élimine le risque d'une mauvaise orientation lors de la connexion avec les réceptacles dans lesquelles doivent être insérées les extrémités libres des languettes de connexion.

Un objet de la présente invention est un procédé de réalisation d'un circuit électrique tel que défini dans la revendication 1.

Un autre objet de la présente invention est un circuit électrique obtenu selon le procédé ci-dessus, tel que défini dans la revendication 3, pliées formant au moins deux rangées de languettes de connexion et lesdites rangées étant situées dans des plans différents.

Un autre objet de la présente invention concerne un commutateur comprenant un circuit électrique tel que défini dans la revendication 3, ledit commutateur pouvant être utilisé dans de nombreuses applications telles que commande de feux de détresse, d'anti-brouillard, dégivrage du pare-brise.

Un avantage de la présente invention réside dans le fait qu'on groupe toutes les languettes de connexion d'un même côté et de réaliser aussi bien une connexion interne qu'une connexion externe tout en utilisant qu'une seule plaque circuit découpée au lieu de plusieurs plaques circuits empilées les unes sur les autres, comme c'est le cas dans les documents cités précédemment.

Un autre avantage de la présente invention réside dans le fait qu'on utilise la surface de la plaque circuit au maximum de ses possibilités tout en ayant la possibilité d'avoir des languettes de connexion sur deux plans et même si nécessaire de longueurs différentes.

Le positionnement des languettes de connexion suivant deux rangées et en nombre total impair, on oriente automatiquement lesdites languettes par rapport aux réceptacles.

D'autres avantages et caractéristiques ressortiront mieux à la lecture de la description d'un mode de réalisation préféré de l'invention, ainsi que des dessins annexés sur lesquels :

La figure 1 est une vue en perspective d'un circuit électrique découpé suivant la présente invention.

La figure 2 est une vue en coupe d'un commutateur comprenant le circuit représenté sur la figure 1.

La figure 3 est une autre vue en coupe du commutateur représenté sur la figure 2.

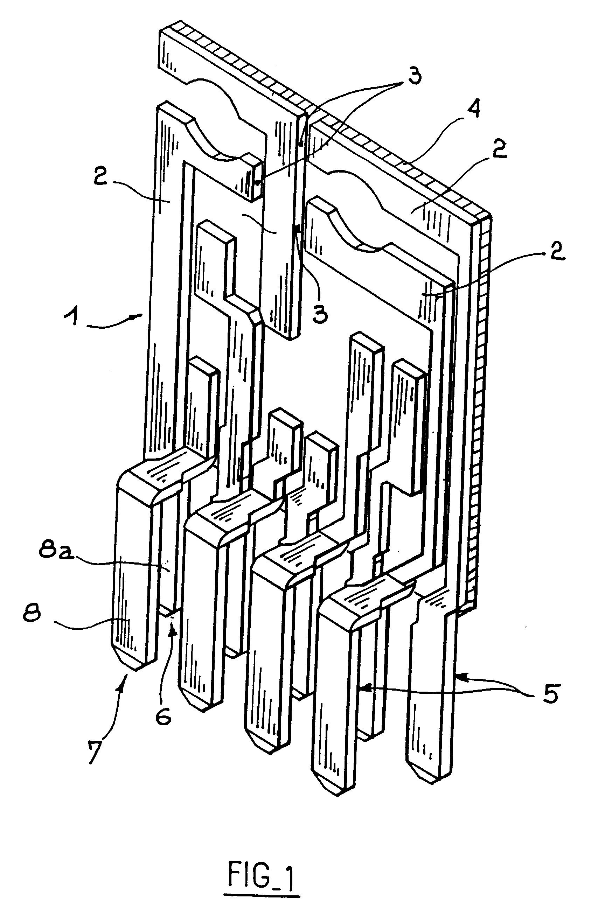

Le procédé selon l'invention consiste à découper une plaque conductrice de manière à constituer un circuit électrique 1 comportant des pistes conductrices 2 pour le passage de courant. Les pistes conductrices 2 sont reliées par des pontets de liaison 3 qui sont éliminés après surmoulage, au moyen d'un outil de découpe approprié, le surmoulage d'une ou des deux faces des pistes conductrices 2 étant réalisé avec un matériau adéquat. Dans l'exemple représenté sur la figure 1, le circuit découpé est surmoulé sur une face par un surmoulage 4.

Un côté du circuit électrique 1 est découpé de manière à former des bandes juxtaposées 5 dont certaines sont pliées deux fois, de préférence sensiblement à angle droit, de façon que les parties externes soient disposées en avant des bandes non pliées. Dans un mode de réalisation préféré de l'invention une bande 5 sur deux est pliée de manière à réaliser deux rangées parallèles 6 et 7 de bandes. Chaque rangée étant disposée dans sensiblement un même plan. De la sorte, les parties terminales qui constituent des languettes de connexion 8 et 8a sont disposées en quinconces, les languettes de connexion avant 8 étant situées entre et en avant des languettes de connexion arrière non pliées 8a.

Pour améliorer la tenue du circuit électrique 1, le surmoulage 4 se poursuit jusqu'au niveau de la première pliure des bandes 5 au moins, et de préférence au delà de ladite pliure, ainsi que cela est représenté sur la figure 1.

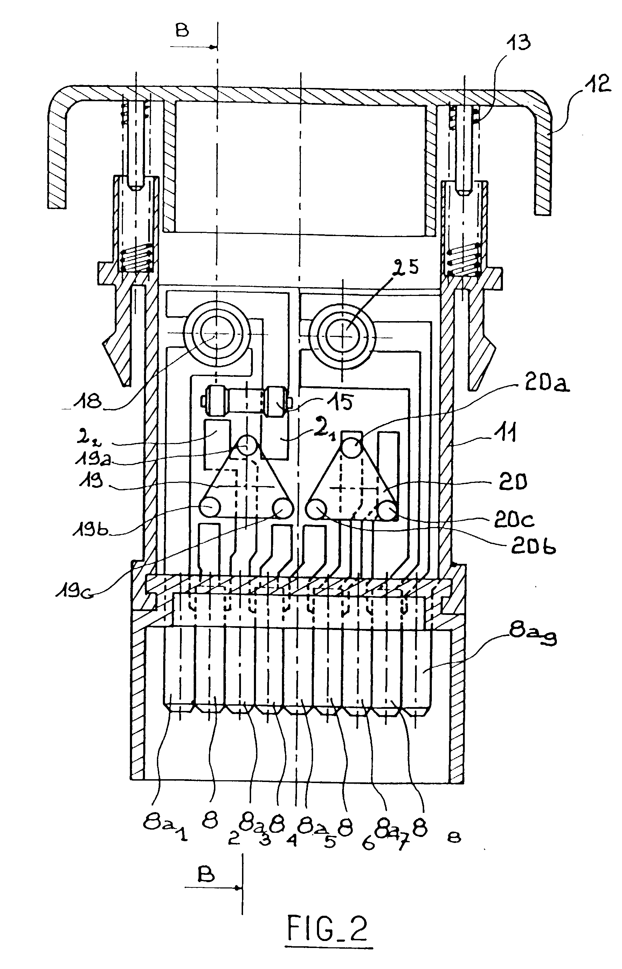

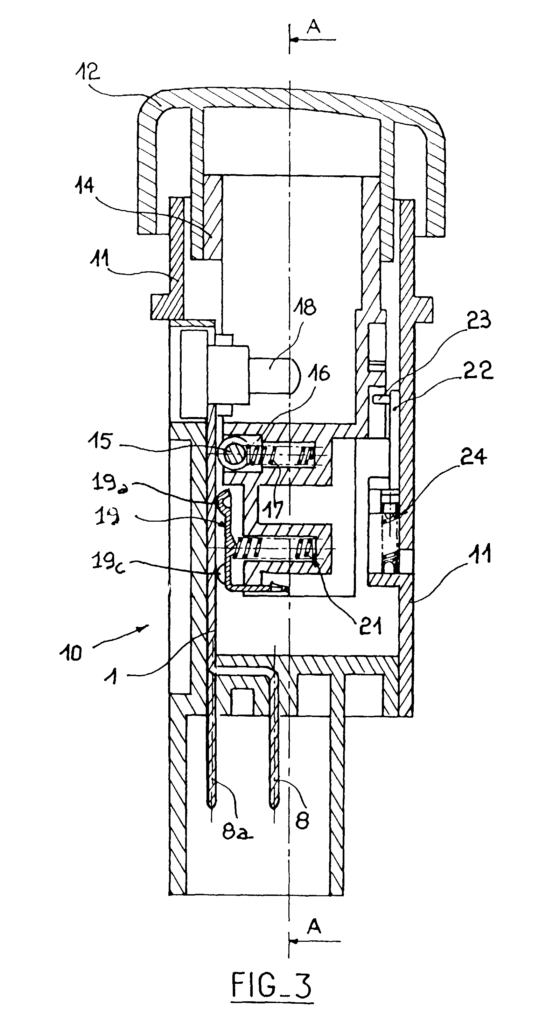

Ainsi qu'on peut le voir sur la figure 1, le circuit électrique 1 obtenu selon le procédé ci-dessus comprend des pistes conductrices 2 indépendantes mais qui sont fixes grâce au surmoulage 4. Les pistes conductrices peuvent être à leur tour découpées pour permettre le passage de certains composants, une telle découpe étant effectuée en même temps que la découpe du circuit proprement dit. Les pistes conductrices peuvent être reliées électriquement entre elles au moyen d'organes spécifiques tels que des contacts mobiles comme cela sera décrit ci-après, en référence aux figures 2 et 3, et leurs configurations et dimensions sont adaptées à l'application particulière du circuit 1.

Sur les figures 2 et 3 sont représentés deux coupes différentes d'un même commutateur comprenant le circuit électrique 1, décrit ci-dessus et utilisé pour la commande des feux de détresse visibles à l'arrière d'un véhicule.

Le commutateur 10 comprend un boîtier 11, qui est muni d'une touche de commande 12 susceptible d'occuper les deux positions enfoncée et libérée et qui est sollicitée par un ressort 13, comme cela est réalisé de manière usuelle dans ce type de commutateur. Dans le boîtier 11 est monté un coulisseau 14 qui entraîne tous les contacts mobiles du commutateur.

Une haltère 15 est montée dans un évidement 16 du coulisseau et elle est soumise à l'action d'un ressort 17 qui tend à l'appliquer constamment sur le circuit conducteur 1. L'haltère 15 est un contact mobile qui permet de réaliser la connexion électrique entre deux pistes conductrices, sur lesquelles est connecté un témoin de fonctionnement, par exemple une lampe témoin 18. Deux contacts à trois points 19 et 20 sont également montés dans le boîtier 11. Les contacts 19 et 20 sont chacun soumis à un ressort de poussée 21 et sont entraînés ensemble par le coulisseau 14, de manière à amener les points de contact 19a à 19c ou 20a à 20c sur certaines des pistes 2 du circuit 1, de sorte qu'une liaison électrique est établie avec des organes électriques d'un boîtier d'interconnexion (non représentés) par l'intermédiaire des languettes de connexion 8 ou 8a.

Une pièce 22 munie d'un doigt d'indexage 23 est disposée dans le boîtier 11 et soumise à l'action d'un ressort 24. Le doigt d'indexage 23 coopère avec une came, non représentée, pour permettre le blocage et le déblocage de la touche de commande 12, comme cela est usuellement connu et réalisé.

Une autre lampe témoin 25 est également prévue et elle coopère avec le contact à trois points 20.

Une pression sur la touche de commande 12 entraîne un déplacement du coulisseau 14 qui entraîne, à son tour, l'haltère 15 et les contacts à trois points 19 et 20, qui sont solidaires. L'haltère 15 réalise alors une liaison électrique entre les pistes 2₁ et 2₂, la piste 2₂ étant solidaire de la languette de connexion 8a₃.

Le contact 19 relie, par ses points 19a à 19c, les languettes de connexion 8₂, 8a₃ et 8₄, tandis que le contact 20 relie, par ses points 20a à 20c, les languettes de connexion 8a₅, 8₆ et 8a₇.

En position de repos, comme cela est visible sur la figure 2, le contact 19 ne relie pas de languettes de connexion entre elles, alors que, dans le même état de repos, deux languettes de connexion 8₆ et 8a₇ sont reliées par le contact 20.

## Revendications

1. Procédé de réalisation d'un circuit électrique (1) pourvu de languettes de connexion, consistant à découper une plaque conductrice de manière à ménager des pistes conductrices (2) constituant le circuit et à replier certaines desdites pistes conductrices pour constituer des languettes de connexion (8, 8a), caractérisé en ce qu'un seul côté de ladite plaque conductrice est découpé de manière à ménager des pistes conductrices distinctes (2) susceptibles d'être reliées électriquement entre elles et en ce qu'une partie (5) de certaines desdites pistes découpées sur ce côté sont repliées à une seule de leurs extrémités de telle sorte que les parties repliées soient situées dans au moins un plan différent du plan contenant les pistes conductrices (6) non repliées.

2. Procédé selon la revendication 1, caractérisé en ce qu'une piste conductrice sur deux est repliée de manière à constituer au moins deux rangées de languettes de connexion (5,6), les plans desdites rangées étant sensiblement parallèles.

3. Circuit électrique obtenu selon le procédé des revendications 1 ou 2, caractérisé en ce qu'il est constitué par une plaque conductrice comprenant des pistes conductrices (2₁,2₂) découpées dans ladite plaque et distinctes les unes des autres, des languettes de connexion (8, 8a) étant réalisées par pliage des parties extrêmes de certaines pistes conductrices qui sont situées d'un même côté de ladite plaque conductrice, les parties extrêmes des pistes conductrices non pliées et pliées formant au moins deux rangées de languettes de connexion (5, 6) et lesdites rangées étant situées dans des plans différents.

4. Circuit électrique selon la revendication 3, caractérisé en ce que les plans sont sensiblement parallèles.

5. Circuit électrique selon l'une des revendications 3 ou 4, caractérisé en ce qu'il comprend un nombre impair de languettes de connexion (8, 8a).

6. Circuit électrique selon l'une des revendications 3 ou 5, caractérisé en ce que les languettes de connexion (8) d'une rangée sont disposées en quinconce par rapport aux languettes de connexion (8a) de l'autre rangée.

7. Circuit électrique selon l'une des revendications 3 ou 6, caractérisé en ce qu'au moins la plaque conductrice découpée ainsi que les zones de pliage des pistes conductrices pliées sont surmoulées à l'exception d'une partie des extrémités des languettes de connexion.

8. Commutateur électrique caractérisé en ce qu'il comprend un circuit électrique découpé selon l'une des revendications 3 à 7.

9. Commutateur électrique selon la revendication 8, caractérisé en ce qu'il comprend neuf languettes de connexion et au moins deux niveaux d'éclairage.

## Patentansprüche

1. Verfahren zur Herstellung einer elektrischen Schaltung, welche mit Verbindungszungen versehen ist, bestehend aus dem Ausstanzen einer Leiterplatte derart, um Leiterbahnen (2) auszusparen, welche die Schaltung bilden und aus dem Biegen bestimmter dieser Leiterbahnen, um Verbindungszungen (8, 8a) zu bilden, **dadurch gekennzeichnet**, daß eine einzige Seite dieser Leiterplatte derart ausgestanzt ist, um getrennte Leiterbahnen (2) auszusparen, welche geeignet sind, untereinander elektrisch verbunden zu werden und daß ein Teil (5) der bestimmten dieser ausgestanzten Bahnen auf dieser Seite an einem einzigen ihrer Enden derart gebogen sind, daß die gebogenen Teile mindestens in einer Ebene angeordnet sind, die unterschiedlich ist zu der die nichtgebogenen Leiterbahnen (6) enthaltenenden Ebene.

2. Verfahren nach Anspruch 1, **dadurch gekennzeichnet**, daß eine Leiterbahn von zweien derart umgebogen ist, um mindestens zwei Reihen von Verbindungszungen (5, 6) zu bilden, wobei die Ebenen dieser Reihen im wesentlichen parallel sind.

3. Elektrische Schaltung, die gemäß den Ansprüchen 1 oder 2 erhalten wird, **dadurch gekennzeichnet**, daß sie gebildet wird durch eine Leiterplatte, welche aus dieser Platte ausgestanzte Leiterbahnen (2₁, 2₂) umfasst, die voneinander getrennt sind, durch Verbindungszungen (8, 8a) welche durch Biegen der äußeren Teile bestimmter Leiterbahnen realisiert sind, die auf derselben Seite dieser Leiterplatte angeordnet sind, wobei die äußeren Teile der nichtgebogenen und der gebogenen Leiterbahnen mindestens zwei Reihen (5, 6) von Verbindungszungen bilden und diese Reihen in unterschiedlichen Ebenen angeordnet sind.

4. Elektrische Schaltung nach Anspruch 3, **dadurch gekennzeichnet**, daß die Ebenen im wesentlichen parallel sind.

5. Elektrische Schaltung nach einem der Ansprüche 3 oder 4, **dadurch gekennzeichnet**, daß sie eine ungerade Anzahl von Verbindungszungen (8, 8a) umfaßt.

6. Elektrische Schaltung nach einem der Ansprüche 3 oder 5, **dadurch gekennzeichnet**, daß die Verbindungszungen (8) der einen Reihe in Bezug auf die Verbindungszungen (8a) der anderen Reihe im Zick-Zack versetzt angeordnet sind.

7. Elektrische Schaltung nach einem der Ansprüche 3 oder 6, **dadurch gekennzeichnet**, daß mindestens die ausgestanzte Leiterplatte ebenso wie die gebogenen Zonen der gebogenen Leiterbahnen ausgegossen sind mit Ausnahme eines Teils der äußeren Enden der Verbindungszungen.

8. Elektrischer Schalter, **dadurch gekennzeichnet**, daß er eine elektrische Schaltung umfasst, die nach einem der Ansprüche 3 bis 7 ausgestanzt ist.

9. Elektrischer Schalter nach Anspruch 8, **dadurch gekennzeichnet**, daß er neun Verbindungszungen und mindestens zwei Beleuchtungsebenen besitzt.

## Claims

1. Method of manufacturing an electric circuit (1) having connecting tongues by cutting out a conductive metal sheet to form conductive tracks (2) constituting the circuit and bending some of said conductive tracks to constitute connecting tongues (8, 8a), characterized in that one side of said conductive metal sheet is cut out to form separate conductive tracks (2) which are electric connectable between them and in that a part (5) of some of said tracks cut-out on said side is bent at one end so that the bent parts are in at least one plane different from the place containing the unbent conductive tracks (6).

2. Method according to claim 1, characterized in that alternate conductive tracks are bent to constitute at least two rows of connecting tongues (5, 6), the planes of said rows being substantially parallel.

3. Electric circuit obtained by the method of claim 1 or claim 2, characterized in that it comprises a conductive metal sheet including conductive tracks (2₁, 2₂) cut-out in said metal sheet and separated from each other, connecting tongues (8, 8a) being formed by bending end parts of some conductive tracks situated on the same side of said conductive plate, the end parts of the unbent conductive tracks and bent conductive tracks forming at least two rows of connecting tongues (5, 6) and said rows being in different planes.

4. Electric circuit according to claim 3 characterized in that the planes are substantially parallel.

5. Electric circuit according to claim 3 or claim 4, characterized in that it comprises an odd number of connecting tongues (8, 8a).

6. Electric circuit according to claim 3 or claim 5, characterized in that the connecting tongues (8) of one row are disposed in a quincunx arrangement relative to the connecting tongues (8a) of the other row.

7. Electric circuit according to claim 3 or claim 6 characterised in that at least the cut-out conductive metal sheet and the bent areas of the bent conductive tracks are moulded over except for part of the ends of the connecting tongues.

8. Electric switch characterised in that it comprises a cut-out electric circuit according to any one of claims 3 to 7.

9. Electric switch according to claim 8 characterised in that it comprises nine connecting tongues and is adapted to control at least two levels of illumination.
